(19) Europäisches Patentamt
European Patent Office
Office européen des brevets

(11) Numéro de publication: **0 263 759**
**A1**

(12) **DEMANDE DE BREVET EUROPEEN**

(21) Numéro de dépôt: **87402218.9**

(22) Date de dépôt: **06.10.87**

(51) Int. Cl.⁴: **H 01 L 31/08**
G 01 T 1/14

(30) Priorité: **10.10.86 FR 8614150**

(43) Date de publication de la demande:
**13.04.88 Bulletin 88/15**

(84) Etats contractants désignés: **DE GB IT NL**

(71) Demandeur: **THOMSON-CSF**
**173, Boulevard Haussmann**
**F-75379 Paris Cédex 08 (FR)**

(72) Inventeur: **Micheron, François**
**THOMSON-CSF SCPI 19, avenue de Messine**
**F-75008 Paris (FR)**

**Broussoux, Dominique**
**THOMSON-CSF SCPI 19, avenue de Messine**
**F-75008 Paris (FR)**

(74) Mandataire: **Turlèque, Clotilde et al**
**THOMSON-CSF SCPI 19, avenue de Messine**
**F-75008 Paris (FR)**

(54) **Capteur d'images électrostatiques.**

(57) L'invention concerne un capteur d'images électrostatique. Un exemple de réalisation comporte essentiellement deux électrodes (3. 5), une couche (4) constituée de matériau photoconducteur, et une couche diélectrique (15) constituée par un électret destiné à polariser la couche (4) de photoconducteur, sans nécessiter une source de tension pendant l'enregistrement d'une image. Pendant une phase d'enregistrement, un commutateur (14) courtcircuite les électrodes (3 et 5). Des photoporteurs sont libérés par les rayons X (1) ayant traversé un objet à radiographier (2). Ils se déplacent dans le champ électrique créé par lélectret (15) et tendent à annuler le champ électrique à l'interface des deux couches (4 et 15). Pendant une phase de lecture, le commutateur (14) relie les électrodes (3 et 5) aux entrées d'un amplificateur de courant (8), pendant qu'un faisceau lumineaux (13) balaye la couche (4) de matériau photoconducteur. Les photoporteurs se déplacement et annulent complètement le champ électrique en tout point de l'interface des deux couches (4 et 15). Le courant détecté par l'amplificateur (8) permet d'afficher une image sur un tube cathodique (11). Pendant une phase d'initialisation, la couche (4) de matériau photoconducteur est ramenée à l'état neutre au moyen d'un générateur de tension continue (12) connecté aux électrodes (3 et 5) par le commutateur (14).

Application aux capteurs d'images pour la radiologie.

FIG_1

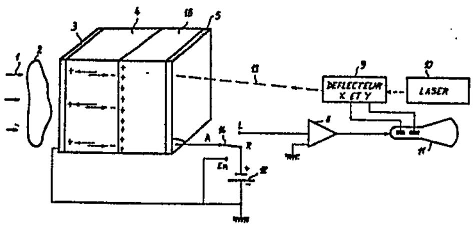


EP 0 263 759 A1

## Description

Capteur d'images électrostatique

L'invention concerne un capteur d'images électrostatique, fournissant un signal électrique représentant une image portée par un rayonnement non visible, par exemple des rayons X. Dans ce type de capteur d'images, une image latente est enregistrée sous la forme d'une répartition spatiale de charge d'espace, à l'interface d'une couche de matériau photoconducteur et d'une couche de matériau diélectrique ; puis une lecture de cette image latente est effectuée point par point en compensant cette charge d'espace par des photoporteurs libérés par un fin faisceau lumineux balayant la couche de matériau photoconducteur. Deux électrodes permettent de recueillir un signal électrique. La mémorisation à l'interface de la couche photoconducteur et de la couche de diélectrique permet l'analyse et le traitement d'une image à un rythme quelconque, indépendant de la durée d'exposition du capteur au rayonnement.

Il est connu, par exemple par le brevet américain nº 4 446 365, de réaliser un capteur d'image comportant : une couche de diélectrique constituée d'une feuille de polytéréphtalate d'éthylène (PETP, vendu dans le commerce sous le nom de Mylar par la société DUPONT DE NEMOURS), d'une couche de sélénium amorphe, et de deux électrodes entre lesquelles sont situées la couche diélectrique et la couche de sélénium. Pendant l'enregistrement d'une image latente, une tension de 2000 volts est appliquée aux électrodes afin de polariser la couche de photoconducteur. Pendant la phase de lecture de l'image latente, les deux électrodes sont reliées à l'entrée d'un amplificateur de courant qui convertit l'intensité du courant de décharge de la couche de matériau photoconducteur, sous l'action du balayage lumineux, en un signal vidéo observable sur un tube cathodique.

Ce type de capteur d'image est utilisable notamment pour remplacer les films photographiques dans les installations classiques pour examens radiologiques. Dans une telle application le capteur est placé dans une installation classique, à la place du film photographique pour enregistrer une image latente, puis est placé dans un dispositif de lecture afin de restituer une image sur un tube cathodique. L'image latente persiste quelques heures, cela permet donc de réaliser éventuellement l'enregistrement et la lecture en deux lieux différents.

Le capteur d'images de type connu a pour inconvénient de nécessiter une source de haute tension pendant l'enregistrement; ce qui implique une modification de l'installation classique de radiologie pour y incorporer cette source.

Le but de l'invention est de permettre d'enregistrer une image latente dans le capteur sans que celui-ci nécessite une source de tension.

L'objet de l'invention est un capteur d'images électrostatique ayant la même structure que le dispositif de type connu mais où la couche de matériau diélectrique est constituée par un électret destiné à polariser, de manière électrostatique, la couche de matériau photoconducteur.

Selon l'invention, un capteur d'image électrostatique comportant :

- une couche de matériau photoconducteur sous l'action d'un rayonnement porteur d'une image à capter, et sous l'action de lumière visible ;
- une couche de matériau diélectrique ;
- deux électrodes , les deux couches susdites étant intercalées entre ces deux électrodes ;
- des moyens de balayage lumineux, pour illuminer successivement chaque portion de la couche de matériau photoconducteur, selon un chemin prédéterminé ;
- des moyens couplés aux deux électrodes susdites pour fournir des signaux électriques représentant l'intensité du courant de décharge de la couche de matériau photoconducteur pendant le balayage lumineux ;

est catactérisé en ce que la couche de matériau diélectrique est un électret, pour polariser la couche de matériau photoconducteur.

L'invention sera mieux comprise et d'autres détails apparaîtront à l'aide de la description suivante et des figures l'accompagnant :

- La figure 1 représente le schéma synoptique d'un exemple de réalisation du capteur d'image, selon l'invention ;
- La figure 2a à 2d illustrent le fonctionnement de cet exemple de réalisation ;
- La figure 3 illustre le fonctionnement de cet exemple de réalisation dans un autre mode d'utilisation ;
- Les figures 4 et 5 représentent deux variantes de réalisation du capteur selon l'invention.

Sur la figure 1, l'exemple de réalisation représenté comporte essentiellement : une couche 15 constituée d'un électret ; une couche 4 constituée de matériau photoconducteur ; une première électrode 3 et une seconde électrode 5 situées de part et d'autre des couches superposées 15 et 4 ; un commutateur 14 à un circuit et trois positions ; un amplificateur de courant ; un déflecteur de faisceau lumineux 9 ; un laser 10 ; un tube cathodique 11 ; et un générateur de tension continue 12.

Dans cet exemple, un faisceau de rayons X, 1, est projeté à travers un objet 2 à radiographier. Les rayons X qui ont traversé l'objet 2 sont reçus par la couche 4 à travers l'électrode 3 qui est transparente aux rayons X. L'électrode 3 est reliée à un potentiel de référence, alors que l'électrode 5 est reliée à un point commun A du commutateur 14. Le commutateur 14 a une primière position, notée En, dans laquelle le point commun A est relié au potentiel de reference ; une seconde position, notée L, dans laquelle le point commun A est relié à une entrée de l'amplificateur de courant 8 ; et une troisième position notée R, dans laquelle le point commun A est

relié à la borne positive du générateur 12. La borne négative du générateur 12 est reliée au potentiel de référence, de même qu'une second entrée de l'amplificateur de courant 8. Une sortie de l'amplificateur de courant 8 est reliée au wehnelt du tube cathodique 11.

Comme dans les capteurs d'images de type connu, le fonctionnement du capteur selon l'invention comporte une phase d'enregistrement d'une image latente, pendant laquelle le commutateur 14 est dans la position En, et une phase de lecture de l'image latente pendant laquelle le commutateur 14 est dans la position L.

Selon une première variante d'utilisation du capteur selon l'invention, il est prévu une troisième phase de fonctionnement permettant d'initialiser le capteur pour enregistrer une nouvelle image. Pendant cette phase d'initialisation, le commutateur 14 est dans la position R.

Pendant la phase de lecture, la couche 4 est balayée par un faisceau lumineux 13 à travers la seconde électrode 5 et à travers la couche 15 qui sont transparentes. Le laser 10 fournit le faisceau lumineux 13 qui est dévié selon deux directions perpendiculaires notées X et Y, par le déflecteur 9. Ce dernier possède deux sorties couplées respectivement à des électrodes de déviations verticales et de déviations horizontales du tube cathodique 11 pour commander un balayage synchrone dans le tube cathodique 11. Le déflecteur 9 est de réalisation classique, à la portée de l'homme de l'art.

L'électret constituant la couche 15 est un film diélectrique dans lequel ont été implantées des charges positives ou négatives, à une faible profondeur en dessous de l'une des surfaces de ce film. Par exemple, dans du polytétrafluoréthylène, ces charges peuvent être implantées à environ 1 micron sous la surface. Cette implantation peut être considérée comme permanente car la conductivité de ce diélectrique est pratiquement non mesurable. La face de l'électret portant les charges est celle en contact avec la couche 4. Ces charges étant très voisines de la surface du diélectrique, elles peuvent être considérées comme piégées à sa surface. Le matériau photoconducteur se comporte comme un diélectrique dans l'obscurité. Par contre, des paires de photoporteurs sont libérées quand ce matériau est illuminé soit par des rayons X soit par des rayons lumineux.

Les figures 2a à 2d illustrent le fonctionnement de cet exemple de réalisation. Sur la figure 2a, le commutateur 14 est dans la position En, pour permettre au capteur d'enregistrer une image. Le champ électrique E dans la couche de l'électret 15 a une valeur uniforme $E_2$ et le champ électrique dans la couche de matériau photoconducteur 4 a une valeur uniforme $E_1$. La courbe en pointillés représente la valeur algébrique du champ électrique à travers le capteur d'images. Si l'électret et le matériau photoconducteur ont des constantes diélectriques égales et des épaisseurs égales, les valeurs $E_1$ et $E_2$ sont égales en valeur absolue et de signes opposés.

La figure 2b illustre le fonctionnement pendant la phase d'enregistrement proprement dite, c'est-à-dire lorsque des rayons X, 1, traversent un objet 2, puis vont libérer des photoporteurs dans la couche 4. En chaque point de la couche 4, le nombre de photoporteurs libérés est proportionnel à la dose de rayons X reçue. Ils se déplacent sous l'action du champ électrique $E_1$ créé par l'électret 15 dans la couche 4, et créent à leur tour un champ électrique tendant à annuler le champ $E_1$. Si la dose de rayons X reçue est suffisante les photoporteurs se déplacent en nombre suffisant pour annuler le champ électrique $E_1$au niveau de l'interface des couches 4 et 15, en créant un champ exactement opposé. La dose de rayons X n'étant pas uniforme, et étant inférieure à celle correspondant à un tel nombre de photoporteurs, une image latente est donc stockée sous la forme d'une répartition non uniforme du champ électrique dans la couche 4 et dans la couche 15.

La figure 2c représente le fonctionnement pendant la phase de lecture. Le commutateur 14 est dans la position L afin de relier les électrodes 3 et 5 aux entrées de l'amplificateur de courant 8 qui se comporte comme un court-circuit. Le faisceau lumineux 13 balaye successivement chaque point de la couche 4 et son intensité lumineuse est choisie telle qu'elle permette de libérer suffisamment de photoporteurs pour que, après leur déplacement, ils annulent complètement le champ électrique $E_1$ en tous points de l'interface des couches 4 et 15. Les photoporteurs créés par le faisceau lumineux 13 réalisent donc la saturation du capteur d'images en complétant le déplacement créé par le balayage lumineux se traduit par un courant électrique détecté par l'amplificateur 8 et fournit donc un signal de lecture séquentielle de l'image latente. Ce courant représente donc l'image latente en négatif. Quand la saturation est atteinte, le champ électrique est voisin de 0 à l'interface entre les couches 4 et 15, comme représenté par le graphe de E sur la figure 2c, et le mouvement des photoporteurs cesse.

Si la charge par unité de surface de l'électret est $s_0$, la saturation de cette unité de surface est atteinte si une charge $s_0/2$ a circulé d'une électrode à l'autre en passant par le circuit extérieur fermé par le commutateur 14. Pendant l'enregistrement d'une image, une charge $x.s_0$ se déplace vers l'électrode 3, la valeur du coefficient x étant comprise entre 0 et $^1/_2$. Pendant la phase de lecture, le même unité de surface est amenée à la saturation, en engendrant un courant de charges de valeur $(1/2 - x).s_0$ qui constitue le signal de lecture détecté par l'amplificateur 8.

La figure 2 d représente la phase d'initialisation du capteur, autrement dit la phase d'effacement de l'image latente. Cette phase consiste à éclairer chaque point de la couche 4 avec une illumination uniforme 16, suffisante pour libérer un nombre de photoporteurs au moins égal à la somme des photoporteurs libérés au cours de l'étape d'enregistrement et au cours de l'étape de lecture de l'image latente,et consiste à appliquer un champ électrique permettant de déplacer ces photoporteurs pour ramener à l'état neutre l'ensemble de la couche 4. Le champ électrique est fourni par le générateur de tension 12, sa tension étant choisie égale, en valeur absolue, à la tension dite tension équivalente de l'électret, qui est le potentiel créé par l'électret à l'interface des couches 4 et 15. Le champ créé par le générateur 8 fait circuler une charge $s_0/2$ pour chaque

unité de surface du capteur. Quand les photoporteurs ont terminé leur déplacement le champ résultant à l'interface des couches 4 et 15 est nul et le matériau de la couche 4 est uniformément neutre.

L'illumination uniforme 16 peut être fournie par un balayage analogue au balayage du faisceau 13 utilisé pour la lecture, mais ayant une intensité ou une durée supérieure à celle du balayage du faisceau 13. Le commutateur 14 est remis ensuite dans la position En, comme représenté sur la figure 2a, dans l'attente de l'enregistrement d'une nouvelle image.

La figure 3 représente une variante de réalisation d'un capteur d'images selon l'invention, et illustre le fonctionnement de cette variante pendant la phase de lecture et d'initialisation, ces deux phases étant confondues. Cette variante de réalisation comporte des électrodes 3, 5, et des couches 4 et 15 qui sont inchangées. Par contre, le circuit électrique relié aux électrodes 3 et 5 est différent de celui décrit précédemment. Un commutateur 14′ à un circuit et deux positions comporte un point commun K relié à l'électrode 3.

Pendant la phase d'enregistrement, non représentée, le commutateur 14′ est dans une première position, notée W, dans laquelle il relie directement l'électrode 3 à l'électrode 5. Pendant la phase de lecture et d'initialisation, le commutateur 14′ est dans une seconde position notée R, dans laquelle il relie l'électrode 3 à la borne positive d'une générateur de tension continue 12′. La borne négative du générateur 12′ est reliée à l'électrode 5 par l'intermédiaire de deux entrées d'un amplificateur de courant 8′ analgue à l'amplificateur de courant 8 de l'exemple de réalisation précédent.

Pendant la phase de lecture, un faisceau lumineux 13 balaye la couche 4 après avoir traversé l'électrode 5 et l'électret 15. Le faisceau 13 est fourni par de moyens analogues à ceux de l'exemple de réalisation précédent. Les photoporteurs libérés dans la couche 4 par le faisceau 13 se déplacent sous l'action du champ électrique créé par le générateur 12′ et se recombinent, ce qui permet de ramener la couche 4 à la neutralité correspondant à l'état initial du capteur. Pendant le déplacement des photoporteurs un courant circule à travers le générateur 12′ et l'amplificateur de courant 8′, traduisant directement la dose de rayons X absorbée au point qui est en cours d'illumination par le faisceau 13. La valeur de ce courant est complémentaire de celle obtenue au cours de la lecture dans l'exemple de réalisation décrit précédemment.

La tension du générateur 8′ est choisie égale à la tension dite équivalente à l'électret et qui est égale à son potentiel de surface à l'interface des couches 4 et 15. Ainsi le champ électrique résultat est nul dans la couche 4 près de l'interface des couches 4 et 15, quand la couche 4 est revenue à la neutralité.

Dans cet exemple, la couche 4 est constituée d'une couche de sélénium amorphe ayant une épaisseur de 160 microns. La couche 15 est constituée d'un électret en PTFE de 60 microns.

Le matériau photoconducteur est choisi tel qu'il permette la fabrication de couches de grandes surfaces, de l'ordre de quelques décimètre carrés, qu'il absorbe les rayons X avec une bonne efficacité, et qu'il absorbe aussi le faisceau lumineux de lecture avec une bonne efficacité. Il est à noter que l'épaisseur du matériau photoconducteur doit être relativement importante pour une bonne efficacité de l'absorption des rayons X. Cette épaisseur doit être, de préférence supérieure à l'inverse du coefficient d'absorption du matériau pour la longueur d'onde des rayons X à absorber.

D'autre part, le signal de lecture est maximal lorsque la capacité électrique de la couche de photoconducteur est égale à celle de la couche de diélectrique. Les épaisseurs de ces deux couches 4 et 15 doivent donc être choisies en tenant compte de ces conditions.

Dans cet exemple l'électrode 3, est une électrode ohmique constituée d'une couche d'aluminium évaporé dont l'épaisseur est de l'ordre 0,1 micron et l'électrode 5 est une électrode ohmique transparente constituée d'une couche d'oxyde d'étain de 0,01 micron.

La couche 15 est constituée de préférence de PTFE ou de l'un de ces copolymères PTFE-FEP et PTFE-PFA, de formules :

\- PTFE 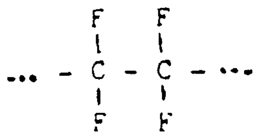

\- PTFE FEP 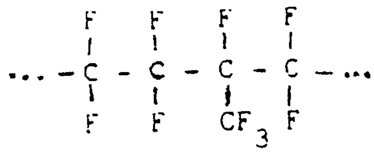

\- PTFE PFA 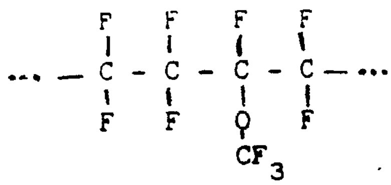

De même, le polypropylène peut être utilisé dans les mêmes conditions:

\- PP : 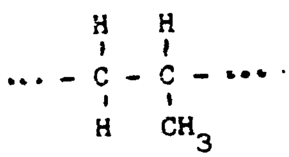

La charge de l'électret est effectuée classiquement par la méthode Corona, qui consiste, dans sa version la plus simple, à placer le diélectrique sur un plan au potentiel zéro, et à disposer à quelques centimètres au-dessus de la face supérieure, un ou plusieurs pointes portées à quelques kilovolts. Un contrôle plus précis de la charge consiste à intercaler, entre le diélectrique et les pointes, une grille portée à un potentiel égal à la tension équivalente d'électret souhaitée. Le temps de charges est de quelques minutes dans l'air, à température ambiante.

Une première variante de réalisation permet de réduire la capacité de la couche 4 de matériau photoconducteur. Cette variante consiste à diviser l'une des électrodes, 3 ou 5, en plusieurs parties isolées électriquement et reliées chacune à un amplificateur de courant indépendant. Une seconde variante permet d'amplifier le signal de lecture par un procédé classique consistant à utiliser une jonction PN polarisée en inverse, cette jonction étant constituée à l'intérieur du matériau photoconducteur de la couche 4.

La figure 4 représente le schéma synoptique d'un troisième exemple de réalisation du capteur selon l'invention comportant ces deux caractéristiques simultanément. Il comporte essentiellement : une couche 24, de matériau photoconducteur ; une couche 35, de matériau électret ; une première électrode 23 et une second électrode 25 situées de part et d'autre des couches 24 et 35, l'électrode 25 étant divisée en une pluralité de bandes 18 identiques. Pour lus de clarté, le nombre des bandes 18 représentées sur la figure est limité à cinq, alors qu'en pratique il peut être de 1024, par exemple. La couche 24 est réalisée en sélénium amorphe dopé de type N et comporte, du côté de l'électrode 25 des diffusions, 36, de matériau dopant de type P. Ces diffusions 36 ont une forme carrée et sont alignées parallèlement aux bandes 18. Dans l'exemple représenté sur la figure 2, cinq séries de diffusion 36 sont alignées respectivement en face des cinq bandes 18. Chaque diffusion 36 constitue une jonction PN indépendante de ses voisines.

La divison de l'électrode 25 en une pluralité de bandes 18 provoque une diminution de la capacité de la couche 24. Elle permet aussi une bonne lecture en parallèle sur chacune des bandes 18, qui permet de ralentir la vitesse de lecture en chaque point du capteur tout en conservant une même durée totale pour la phase d'enregistrement. Cette réduction de vitesse permet de réduire la bande passante de l'amplificateur de courant à relier à chacune des bandes 18. Cette réduction de bande passante réduit la puissance du bruit reçue par cet amplificateur de courant et par conséquent augmente la détectivité du capteur. Une réduction de la capacité d'un facteur 1000 en fractionnant l'électrode 24 en mille bandes 18 identiques et une réduction de la bande passante par un facteur 1000, permettent de multiplier la détectivité par un facteur 1000. La détectivité d'un tel capteur est alors de l'ordre de quelques photons X par pixel.

Dans cet exemple, la lecture est réalisée du côté de l'électrode 23 qui reçoit le rayonnment X. Ce rayonnement et l'objet qu'il traverse ne sont pas représentés sur cette figure pour plus de clarté. La lecture est effectuée par des rayons lumineux 19 projetés sur l'électrode 23 selon une ligne perpendiculaire à la

direction des bandes 18 composant l'électrode 25. Ces rayons lumineux sont fournis par une source 20 de lumière cohérente et sont focalisés par une lentille cylindrique 22 entourée d'un écran opaque 21. L'écran opaque 21 et la lentille 22 sont dèplacés, à une vitesse régulière, dans un plan parallèle au plan de l'électrode 23 afin de réaliser un balayage régulier de celle-ci.

Chaque bande 18 de l'électrode 25 est reliée électriquement au point commun d'un commutateur à un circuit et trois positions notées En, R, L, car il remplit les mêmes fonctions que le commutateur 14 du premier exemple de réalisation représenté sur la figure 1. L'ensemble 26, de tous les commutateurs associés respectivement aux bandes 18 de l'électrode 25, permet de relier toutes les bandes 18 à l'électrode 23 pendant la phase respectivement à des entrées d'un ensemble 27 d'amplificateurs de courant, pendant la phase de lecture ; et il permet de relier toutes les bandes 18 à la borne positive du générateur 17 pendant la phase d'initialisation.

Une autre variante peut comporter un ensemble 26 de commutateurs à deux positions seulement, analogues au commutateur 14' de la figure 3.

Les amplificateurs de courant 27 ont des sorties reliées respectivement à des entrées d'un multiplexeur 28. Ce dernier a une sortie reliée à une borne de sortie 29 pour fournir séquentiallement les valeurs de courant mesurées sur les bandes 18. Le multiplexeur 28 possède aussi une entrée de commande reliée à une borne 30 pour recevoir un signal de commande fourni, par exemple, par un dispositif de calcul destiné à traiter les images recueillies par le capteur d'image. Ce dispositif de calcul commande aussi le déplacement de l'écran opaque 21 porant la lentille 22, pour synchroniser le balayage de lecture et le traitement des images.

D'autres dispositifs de balayage de lecture peuvent être utilisés : par exemple, une fibre optique à diffusion latérale contrôlée, disposée à proximité de l'électrode 23, perpendiculaire à la direction des bandes 18 de l'électrode 25, et déplacée dans un plan parallèle à l'électrode 23.

La figure 5 représente encore une autre variante du dispositif optique de balayage. Il comporte une nappe 33 de fibres optiques, à diffusion latérale contrôlée, dont les fibres 32 sont perpendiculaires à la direction des bandes 18 et qui sont plaquées à la surface de l'une des électrodes du capteur, par exemple l'électrode 23 sur la figure 4. Un dispositif de commutation optique 31 relie une source lumineuse 34 successivement à chacune des fibres 32 constituant la nappe 33. Sur cette figure 5, l'électrode 23, les courches 24 et 35, et l'électrode 25 ne sont par représentées pour plus de clarté. Elles sont identiques à celles de l'exemple de réalisation de la figure 4, de même que les commutateurs 26, les amplificateurs 27 et le multiplexeur 28.

Dans d'autres exemples de réalisation, il est possible de réaliser l'illumination par les rayons X du même côté que le balayage lumineux par le faisceau 19, à travers l'électrode 23.

La couche 25, constituée d'un électret, peut être située éventuellement du côté où arrivent les rayons X, car l'électret n'absorbe pas les rayons X et ne peut donc par être déchargé par ces rayons X.

L'invention est applicable notamment aux capteurs d'images pour les examens radiologiques, mais est applicable aussi aux capteurs pour des rayonnements lumineux ou gammas.

**Revendications**

1. Capteur d'images électrostatique comportant :

- une couche (4) de matériau photoconducteur sous l'action d'un rayonnement porteur d'une image et sous l'action de lumière visible ;
- une couche (15) de matériau diélectrique ;
- deux électrodes (3, 5), les deux couches susdites (4 et 15) étant intercalées entre ces deux électrodes ;
- des moyens de balayage lumineux (9, 10), pour illuminer successivement chaque portion de la couche (4) de matériau photoconducteur, selon un chemin prédéterminé ;
- des moyens (8, 12, 14) couplés aux deux électrodes susdites (3, 5) pour fournir des signaux électriques représentant l'intensité du courant de décharge de la couche (4) de matériau photoconducteur pendant le balayage lumineux ;

caractérisé en ce que la couche (15) de matériau diélectrique est un électret, pour polariser la couche (4) de matériau photoconducteur.

2. Capteur d'images selon la revendication 1, caractérisé en ce que les moyens couplés aux deux électrodes susdites (3, 5), pour fournir des signaux électriques, comportent :

- un générateur de tension (12) ayant une tension égale au potentiel créé par l'électret à l'interface des deux couches (4 et 15) ;
- un amplificateur de courant (8) ;
- un commutateur (14) permettant de relier les électrodes (3, 5) directement à des entrées de l'amplificateur (8) pendant une phase de lecture d'une image latente enregistrée dans la couche (4) de matériau photoconducteur, et permettant de relier les électrodes (3, 5) aux bornes du générateur de tension (12) pendant une phase d'initialisation du capteur d'images.

Capteur d'images selon la revendication 1, catactérisé en ce que les moyens (8, 12, 14) couplés aux deux électrodes susdites (3, 5), pour fournir des signaux électriques, comportent :

- un générateur de tension (12') ayant une tension égale au potentiel créé par l'électret à l'interface

des deux couches (4, 15) ;

- un amplificateur de courant (8′) ;

- un commutateur (14′) permettant de relier les électrodes (3, 5) en série avec les entrées de l'amplificateur (8′) et avec le générateur de tension (12′), pendant une phase de réinitialisation du capteur et de lecture d'une image latente enregistrée dans la couche (4) de matériau photoconducteur ; et permettant de relier ensemble directement les deux électrodes pendant une phase d'enregistrement d'une image latente.

4. Capteur d'images selon l'une des revendications 1 à 3, caractérisé en ce que l'épaisseur de la couche (4) de matériau photoconducteur et l'épaisseur de la couche (15) de matériau diélectrique sont telles que les capacités de ces deux couches ont des valeurs voisines.

5. Capteur d'images selon la revendication 1, caractérisé en ce que la couche (4) de matériau photoconducteur est constituée de sélénium amorphe.

6. Capteur d'images selon la revendication 1, caractérisé en ce que la couche (4) de matériau photoconducteur comporte une jonction PN.

7. Capteur d'images selon la revendication 6, caractérisé en ce que la jonction PN est fractionnée en une pluralité de jonctions PN (36) indépendantes électriquement.

8. Capteur d'images selon la revendication 1, caractérisé en ce que l'une des électrodes (25) est divisée en bandes (18) parallèles et identiques ;

en ce que les moyens de balayage lumineux (20 à 22) projettent à travers l'une des électrodes (23, 25) une ligne lumineuse (19) perpendiculaire aux bandes (18) et qui est déplacée le long des bandes (18) :

et en ce que les moyens (27 à 30) pour fournir des signaux électriques fournissent en parallèle une pluralité de signaux représentant respectivement l'intensité de décharge de la couche (24) de matériau photoconducteur dans chacune des bandes (18).

9. Capteur d'images selon la revendication 1, caractérisé en ce que les moyens de balayage lumineux comportent une nappe (33) de fibre optiques (32) à diffusion latérale contrôlée, appliquée contre l'une des électrodes (23, 25), les fibres étant perpendiculaires aux bandes (18) et couplées à une source lumineuse (34) par un dispositif de commutation optique (31) ; et en ce que les moyens (27) pour fournir des signaux électriques, fournissent en parallèle une pluralité de signaux représentant respectivement l'intensité de décharge de la couche (24) de matériau photoconducteur dans chacune des bandes (18).

FIG_1

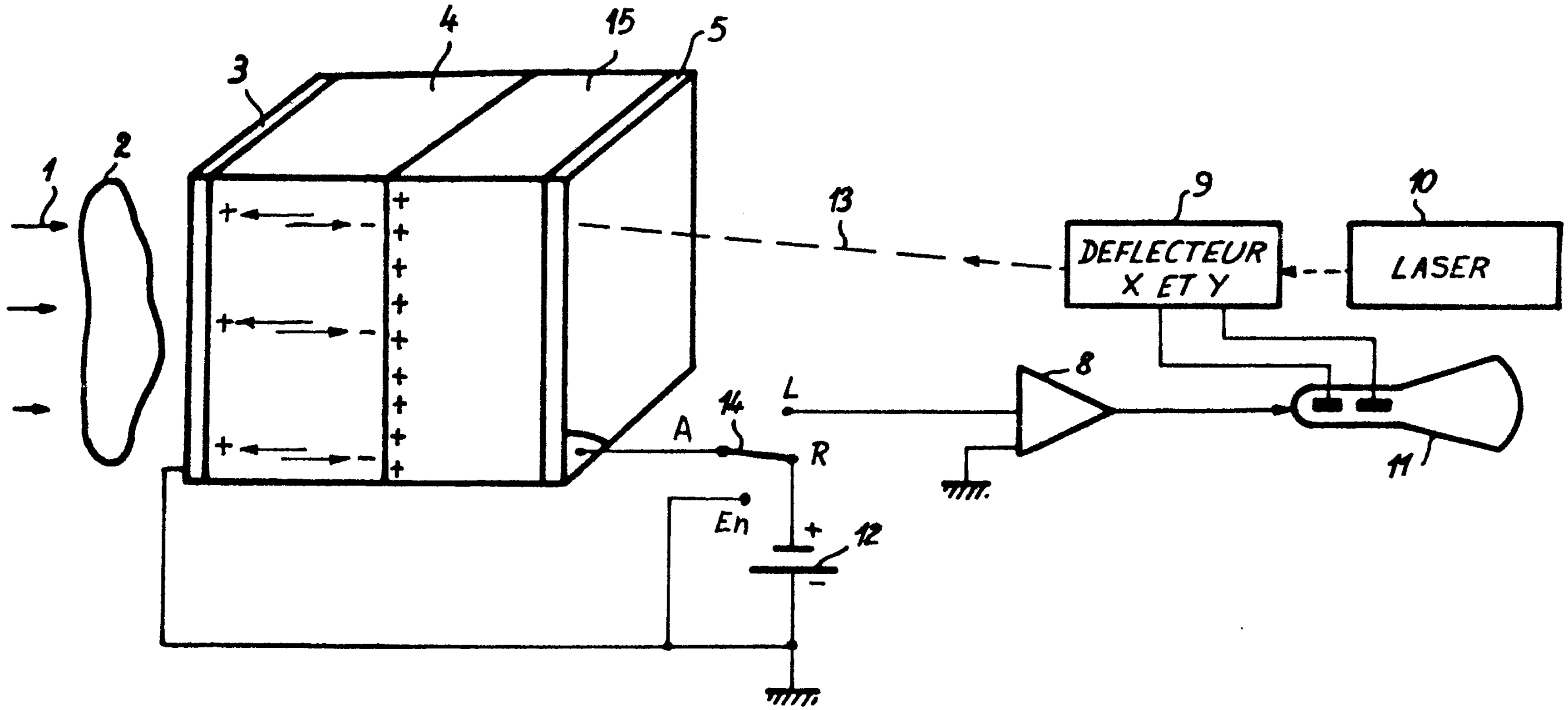

0263759

FIG_2a

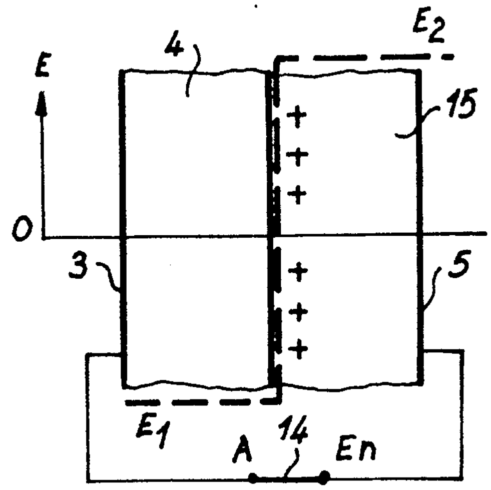


FIG_2b

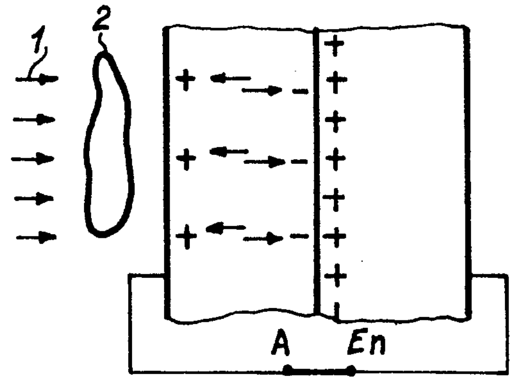


FIG_2c

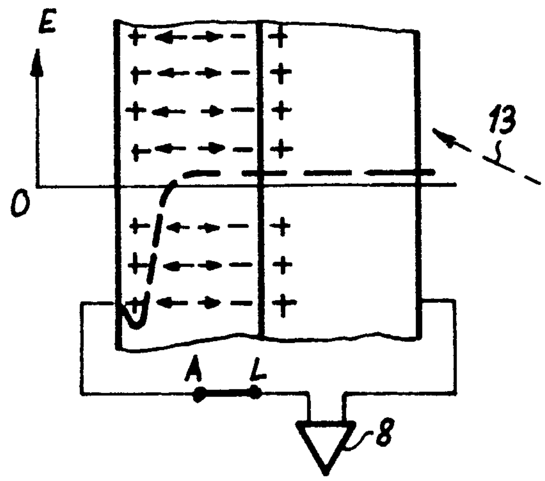


FIG_2d

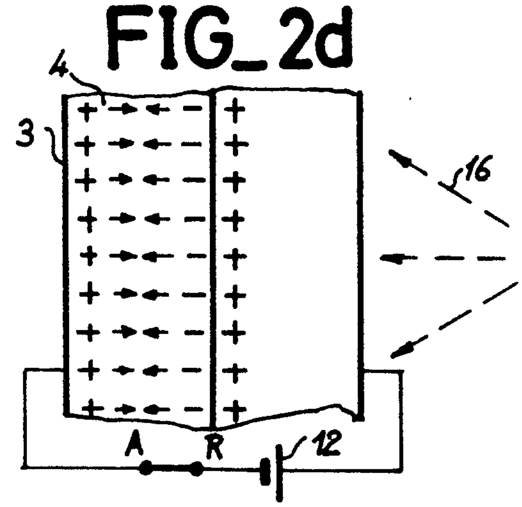


FIG_3

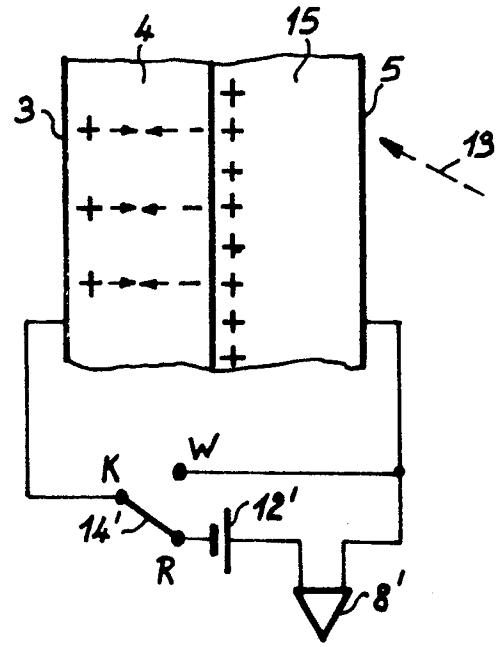

0263759

FIG_4

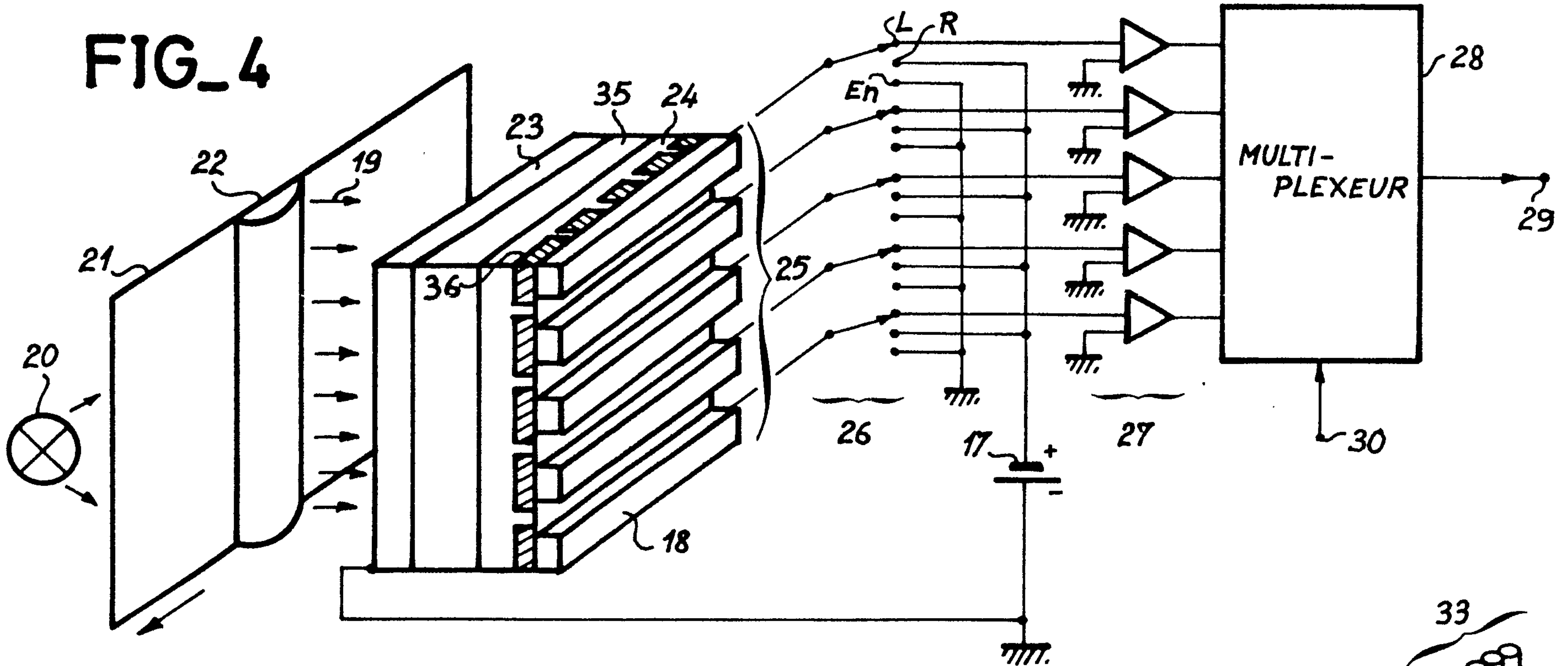


FIG_5

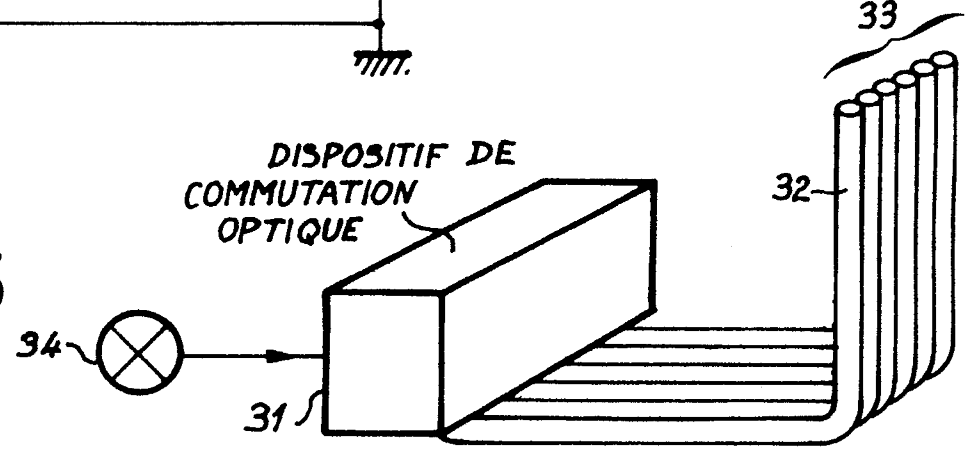

Office européen des brevets

# RAPPORT DE RECHERCHE EUROPEENNE

Numero de la demande

EP 87 40 2218

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 268 750 (R.W. COWART)<br>* Colonne 5, ligne 47 - colonne 6, ligne 22; colonne 7, ligne 56 - colonne 9, ligne 16; figures 1-10 *<br>--- | 1,4,5 | H 01 L 31/08<br>G 01 T 1/14 |
| A | GB-A-2 037 077 (GENERAL ELECTRIC CO.)<br>* En entier *<br>--- | 1,2,5,8 | |
| A | US-A-4 288 264 (PROMOD HAQUE)<br>* En entier *<br>--- | 1,6,7 | |
| A | FR-A-2 446 490 (THOMSON-CSF)<br>* Revendications *<br>--- | 1 | |
| A | KERNENERGIE, vol. 27, no. 5, mai 1984, pages 178-185, Berlin Est, DD; G. PRETZSCH: "Elektretdosimetrie"<br>--- | | |
| A | FR-A-2 518 818 (SIEMENS AG)<br>----- | | |

| DOMAINES TECHNIQUES RECHERCHES (Int. Cl.4) |
|---|
| H 01 L<br>G 01 T<br>G 21 K 4 |

Le présent rapport a été établi pour toutes les revendications

| Lieu de la recherche | Date d'achèvement de la recherche | Examinateur |
|---|---|---|
| LA HAYE | 04-01-1988 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant